# EUROPÄISCHE PATENTSCHRIFT

(11) **EP 0 625 588 B1**
(45) Veröffentlichungstag und Bekanntmachung des Hinweises auf die Patenterteilung: **24.10.2001**
(21) Anmeldenummer: 94107638.2
(22) Anmeldetag: 17.05.1994
(51) Int. Cl.: C23C 16/26

(54) **Plasmapolymer-Schichtenfolge als Hartstoffschicht mit definiert einstellbarem Adhäsionsverhalten**
Plasmapolymer layer sequence as hard material layer with specifically adjustable adhesion behaviour
Polymère de plasma placé en lits à titre de couche dur à pouvoir adhésif adjustable à une valeur définié

(30) Priorität: 21.05.1993 DE 4317029
(43) Veröffentlichungstag der Anmeldung: 23.11.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: Grischke, Dr. Martin, D-22763 (DE); Trojan, Klaus, D-20255 Hamburg (DE)
(74) Vertreter: Einsel, Martin, Dipl.-Phys.

(56) Entgegenhaltungen:
- EP-A- 0 304 220
- EP-A- 0 395 198
- EP-A- 0 413 853
- EP-A- 0 509 875
- EP-A- 0 522 979
- DE-A- 3 807 755
- RÖMPP Lexikon der Chemie 10. Aufl. Bd. 5. S. 4112, 1747, 4533
- ASTM Standard D 3359-95, S. 350 - 356

## Beschreibung

Amorphe Kohlenwasserstoff-(a-C:H) oder auch "Diamond Like Carbon" (DLC) Schichten sind dünne Schichten in einem typischen Dickenbereich von 1 µm bis 5 um und allgemein bekannt. Sie sind vielfältig in der Literatur beschrieben (z. B. J. Robertson "Amorphous Carbon" in Advances in Physics, 1986, Vol. 35, No. 4, S. 317 - 374). Diese Schichten, auch als Plasmapolymerschichten (Hartstoffschichten) bekannt, werden u. a. in einem PECVD-Prozess (Plasma Enhanced Chemical Vapor Deposition) hergestellt. Durch das Anlegen einer HF-Spannung (13.56 MHz) an zwei, in einem Hochvakuum befindliche Elektroden, wird nach dem Einleiten eines geeigneten Gases ein Plasma gezündet und das zu beschichtende Substrat in einem kathodischen Abscheidungsprozess beschichtet. Der Rezipient, elektrisch auf Nullpotential geschaltet, übernimmt gleichzeitig die Funktion der Gegenelektrode. Als Plasmagase werden üblicherweise reaktive Kohlenwasserstoffgase, insbesondere Acetylen (C₂H₂) verwendet. Die Kohlenwasserstoffmoleküle werden dabei im Plasma in unterschiedliche Bruchstücke aufgespalten und teilweise positiv ionisiert. Die positiv geladenen Teilchen werden in Richtung des auf negativem Potential liegenden Substrates beschleunigt auf dem Substrat abgeschieden und polymerisieren dort als Kohlenwasserstoffschicht. Die auf diese Weise entstehenden Hartstoffschichten zeichnen sich durch besondere Eigenschaften wie z. B. hohe Härte, geringer Verschleiß (Abrieb), kleine Reibwerte (Kenngröße für Reibkräfte zwischen zwei Flächen, z. B. bei Kugellagern), hohe Kratzfestigkeit und chemische Resistenz gegenüber Säuren, Laugen und Lösungsmitteln aus.

Eine weitere Eigenschaft, die man nutzen möchte, ist das Benetzungsverhalten derartiger C-H-Schichten gegenüber Flüssigkeiten bzw. das Adhäsionsverhalten überhaupt gegenüber Gasen, Flüssigkeiten und Festkörpern. Diese Eigenschaften, d. h. ob sich beispielsweise eine Flüssigkeit auf einer Oberfläche ausbreitet oder als kugelförmiger Tropfen ausbildet, hängen direkt von der Oberflächenenergie der abgeschiedenen Schicht ab. Durch eine geeignete Prozessführung, z. B. Druck, Gasfluss, Bias (negative Substratspannung) usw. bei der Schichtabscheidung kann auf die Oberflächenenergie der abgeschiedenen Schicht aber nur geringfügig Einfluss genommen werden.

Um aber diese Schichten mit ihren besonderen Eigenschaften, wie z. B. große Härte und geringer Verschleiß, einem noch wesentlich breiteren Anwendungsgebiet zugänglich zu machen, reicht die Möglichkeit, nur geringfügig auf die Oberflächenenergie und damit auf das Benetzungs- bzw. Adhäsionsverhalten Einfluss nehmen zu können, bei weitem nicht aus.

In der Literatur (z. B. B. Tietke "Langmuir-Blodgett Films for Electronic Applications" in Advanced Materials 2, 1990, No. 5) wird eine Möglichkeit zur Einflussnahme auf die Oberflächenenergie und damit das Benetzungsverhalten beschrieben, bei der zusätzlich Polymerschichten (Wachsschichten) aufgetragen werden. Neben dem Nachteil der nur geringfügigen Variationsmöglichkeit und geringfügigen Einflussnahmemöglichkeit auf die Oberflächenenergie ist hier noch zusätzlich nachteilig, dass das Anwendungsgebiet weiter eingeschränkt wird, da diese Wachsschichten die Eigenschaften einer Hartstoffschicht (z. B. Härte, Verschleißfestigkeit usw.) nicht besitzen.

Der Erfindung liegt die Aufgabe zugrunde, Hartstoffschichten anzugeben, die die Nachteile des Standes der Technik nicht aufweisen.

Der Erfindung liegt daher die Aufgabe zugrunde, Hartstoffschichten anzugeben, die eine hohe Härte, einen geringen Verschleiß, kleine Reibwerte, hohe Kratzfestigkeit und chemische Resistenz gegenüber Säuren, Laugen und Lösungsmitteln hat.

Insbesondere liegt der Erfindung die Aufgabe zugrunde, das Benetzungs- bzw. Adhäsionsverhalten dieser anzugebenden Hartstoffschichten mit hoher Härte, geringem Verschleiß usw. entsprechend dem jeweiligen Anwendungsfall definiert einzustellen.
Somit besteht die Aufgabe der Erfindung auch darin, eine Hartstoffschicht mit hoher Härte, geringem Verschleiß, kleiner Reibwerte, hoher Kratzfestigkeit und chemischer Resistenz gegenüber Säuren, Laugen und Lösungsmittel anzugeben, die einem breiten Anwendungsbereich zugänglich ist.

Des Weiteren ist es Aufgabe der Erfindung eine Möglichkeit zur Herstellung dieser Hartstoffschichten zu nennen. Die Aufgabe, eine Möglichkeit zur Herstellung dieser Hartstoffschichten zu nennen, beinhaltet auch, dass diese Herstellung vorteilhafterweise auf einer bekannten Methode zur Schichtherstellung basieren sollte.

Diese Aufgabe wird durch die Schicht gemäß Anspruch 5 und das Verfahren zur Herstellung dieser Schicht betreffend gemäß Anspruch 1 erfindungsgemäß gelöst. Ein erfindungsgemäßer Anwendungsbereich wird in Anspruch 7 genannt. Vorteilhafte Ausführungsformen werden in den entsprechenden Abhängigen Ansprüchen 6, 2 bis 4 und 8 bis 10 beansprucht.

Die erfindungsgemäßen Plasmapolymer-Schichtenfolgen sind dabei Hartstoffschichten, die auf Substraten abgeschieden sind und aus einer Funktionsschicht bestehen, die neben den Basiselementen noch Silizium (Si) und Sauerstoff (O) enthalten und die über einen Plasma-Enhanced-Chemical-Vapor-Deposition (PECVD) - Prozess, herstellbar sind. Dabei sind die neben den Basiselementen in der Funktionsschicht enthaltenen Elemente in die Funktionsschicht derart eingebaut, dass in Abhängigkeit vom polaren bzw. dispersen Anteil der Oberflächenenergie der Gase, Flüssigkeiten und/oder Festkörper, mit denen diese Schichten kontaktiert werden, und dem gewünschten Adhäsionsverhalten die Stärke des polaren bzw. dispersen Anteils dieser Funktionsschichten definiert eingestellt werden kann.

Für den Fall, dass die Funktionsschicht nicht problemlos auf dem Substrat aufzubringen ist, ist es vorteilhaft, wenn zwischen Substrat und Funktionsschicht eine der Haftvermittlung zwischen beiden dienende Zwischenschicht (beispielsweise eine mit Acetylen hergestellte Schicht) auf dem Substrat ist, an die sich dann direkt oder über eine Gradientenschicht die Funktionsschicht anschließt. Es ist günstig, wenn die Funktionsschicht eine Schicht auf der Basis von Kohlenstoff und Wasserstoff ist und 1 at-% bis 70 at-% der Elemente Silizium und zusätzlich Sauerstoff enthält. Im Regelfall wird mit den in der Funktionsschicht zusätzlich enthaltenen Element Silizium eine Abnahme und mit Sauerstoff eine Zunahme des Adhäsions- bzw. Benetzungsverhaltens gegenüber Wasser erreicht, was über eine gezielte Einstellung der Prozessparameter beeinflussbar ist.

Allgemein setzt sich die Oberflächenspannung δ additiv aus dem polaren Anteil δ^{p} und dem dispersen Anteil δ^{d} zusammen und gilt sowohl für Festkörper als auch für Flüssigkeiten.

Die Adhäsionskräfte z. B. zwischen Substrat und Flüssigkeit werden bestimmt durch polar/ polar und dispers/dispers Wechselwirkungen. Es wurde gefunden, dass für das Benetzungs- bzw. Adhäsionsverhalten weniger der Wert der gesamten Oberflächenspannung δ als vielmehr die Größe der polaren bzw. dispersen Anteile entscheidend ist. Wird z. B. eine polare Flüssigkeit mit einem unpolaren Festkörper in Kontakt gebracht, so ist das Benetzungsverhalten weit weniger ausgeprägt als bei Verwendung einer polaren Festkörperoberfläche, obwohl die Oberflächenspannung in beiden Fällen identisch ist.

Es wurde nun überraschenderweise gefunden, dass es möglich ist, erfindungsgemäß Hartstoffschichten mit definiert einstellbarem Adhäsionsverhalten zu erhalten, wenn neben den Basiselementen, die Kohlenstoff und Wasserstoff sind, noch Zusatzelemente Silizium und Sauerstoff eingebaut sind. Welche Menge in die Funktionsschicht eingebaut wird, wird vom gewünschten Adhäsionsverhalten und von den Gasen, Flüssigkeiten und/oder Festkörpern, mit denen die Funktionsschichten kontaktiert werden, bestimmt. Das bedeutet, der Einbau erfolgt derart, dass das Adhäsionsverhalten bzw. Benetzungsverhalten der Funktionsschichten in Abhängigkeit vom polaren bzw. dispersen Anteil der Oberflächenenergie der Gase, Flüssigkeiten und/oder Festkörper, mit denen diese Schichten kontaktiert werden, und dem polaren bzw. dispersen Anteil der Oberflächenenergie dieser Funktionsschichten definiert eingestellt werden kann. Dabei kommt neben der Auswahl der in die Funktionsschicht einzubauenden Elemente Si und O₂ auch der Wahl der Prozessparameter, der Reaktivgase usw. eine große Bedeutung zu. So erreicht man beispielsweise ganz allgemein durch eine Erhöhung der negativen Self-Bias eine Zunahme und mit Erhöhung des Prozessdruckes eine Abnahme der Oberflächenenergie. Insbesondere ist für das erfindungsgemäße Verfahren die Auswahl der Reaktivgaskomponenten von Bedeutung.

Aus der EP 0 395 198 sind Hartstoffschichten mit Kohlenstoff und Wasserstoff als Basiselemente bekannt, wobei allgemein darauf verwiesen wird, dass die Eigenschaften dieser Schichten wie Härte, Reibung etc. durch Zusatz von Elementen ausgewählt unter Silizium, Fluor und einer Komponente A, wobei A wahlweise Bor oder Sauerstoff sein kann, eingestellt werden können.
So können z. B. mit Fluor die Reibungseigenschaften und mit Silizium die Anbindung an das Substrat kontrolliert werden.

Erfindungsgemäß werden derartige Schichten mit dem bekannten PECVD-Prozess hergestellt, indem ein die Funktionsschicht abscheidendes Reaktivgas und/oder Reaktivgasgemisch, welches das oder die Elemente, die in die Funktionsschicht eingebaut werden sollen, enthält, dem Prozess zugeführt und die Funktionsschicht auf dem Substrat abgeschieden wird. Unter Umständen ist es zur besseren Haftung der Funktionsschicht auf dem Substrat vorteilhaft, dass vor Zuführung des Reaktivgases in den Prozess eine der Haftvermittlung zwischen Substrat und Funktionsschicht dienende Zwischenschicht abgeschieden wird, wobei der dafür erforderliche Wechsel der Prozessatmosphären ohne Unterbrechung, d. h. direkt, schlagartig oder allmählich schrittweise erfolgen kann. Günstig ist, wenn hierbei der Wechsel zwischen Zwischenschicht und Funktionsschicht über eine Gradientenschicht erfolgt, was durch einen schrittweisen Übergang der Prozessatmosphäre von der die reine Zwischenschicht bildenden zu der die reine Funktionsschicht bildenden Prozessatmosphäre erreicht werden kann. In Abhängigkeit vom Substratmaterial kann die der Haftvermittlung dienende Schicht z. B. aus einer Acetylen- oder Tetramethylsilanatmosphäre abgeschieden werden.

Die Höhe des prozentualen Anteiles der einzubauenden Elemente in der Schicht wird in Abhängigkeit vom polaren bzw. dispersen Anteil der Oberflächenenergie der Gase, Flüssigkeiten und/oder Festkörper, mit denen diese Schichten kontaktiert werden, und dem gewünschten Adhäsionsverhalten über eine geeignete Variation der Prozessparameter und der bzw. des Reaktivgases definiert eingestellt.

Erfindungsgemäß wird als Reaktivgas für die Ausbildung der Funktionsschicht. Hexamethyldisiloxan (HMDSO) und Sauerstoff eingesetzt.

Es hat sich gezeigt, dass die erfindungsgemäßen Hartstoffschichten vorteilhaft in der Haushaltswarenindustrie, vorzugsweise als Schutzschicht gegen Schmierungen, gegen Verschmutzung bzw. Verkalkung insbesondere auf Heizstäben, die mit Wasser in Kontakt kommen (z. B. Heizstäben in Waschmaschinen), in der Lackindustrie (z. B. als Schutzschicht in Düsen von Spritzpistolen oder in Förderpumpen) und Druckindustrie (z. B. bei Benetzungsproblemen in Druckmaschinen), in der Medizintechnik (z. B. Prothetik) und im allgemeinen Maschinenbau (z. B. Schmierung) verwendet werden können.

Das erfindungsgemäße Verfahren bietet erstmalig die Möglichkeit, Plasmapolymer-Schichten, die alle Eigenschaften aufweisen, die eine Hartstoffschicht auszeichnen, zu erhalten, deren Benetzungs- bzw. Adhäsionsverhalten definiert eingestellt werden kann. Das bietet den Vorteil, dass diese Schichten für ein breites Anwendungsgebiet nutzbar sind.

Ein weiterer Vorteil des erfindungsgemäßen Verfahrens besteht in der Möglichkeit, die Schichten auch nach einer bekannten Schichtherstellungsmethode zu erhalten.

Die erfindungsgemäße Hartstoffschicht sowie das erfindungsgemäße Verfahren sollen an nachfolgenden Ausführungsbeispielen näher erläutert werden.

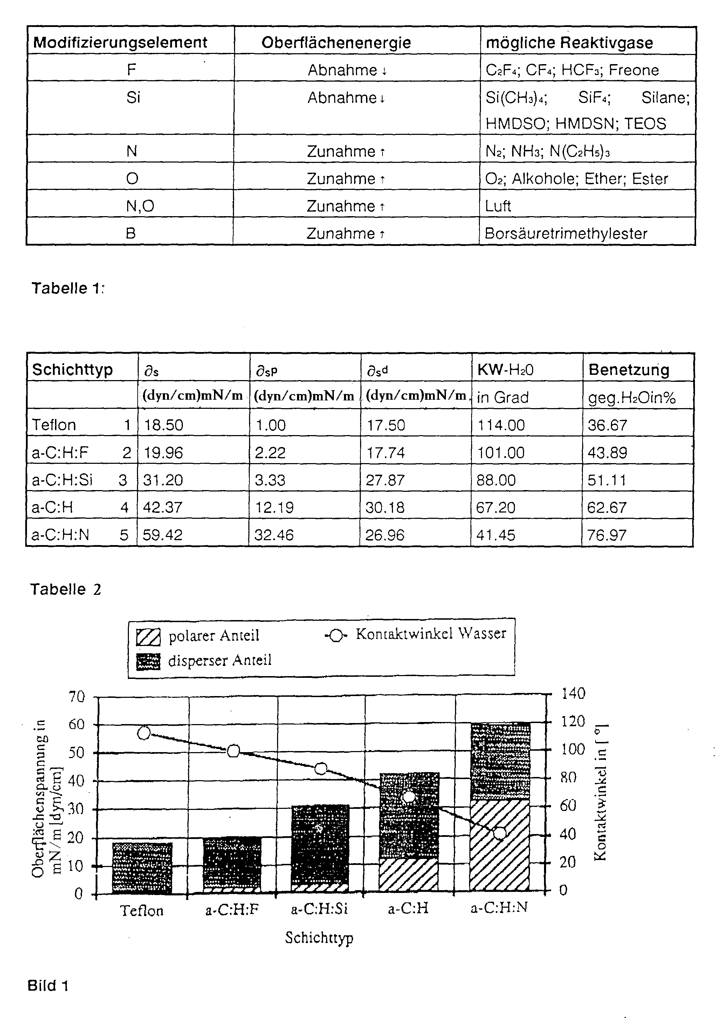

Tabelle 1 zeigt dabei den Einfluss unterschiedlicher Modifizierungselemente auf die Oberflächenspannung, während in Tabelle 2 in Verbindung mit Bild 1 unterschiedlich hergestellte Schichttypen bzgl. ihrer Oberflächenspannung (δₛ), den jeweiligen polaren (δₛ^{p}) und dispersen (δₛ^{d}) Anteilen und dem Benetzungsverhalten gegenüber Wasser in % dargestellt sind. 100% Benetzung bedeutet dabei ein völliges Spreiten (Breitlaufen) eines Wassertropfens auf einer Festkörperoberfläche. Demgegenüber bedeutet 0% Benetzung das genaue Gegenteil davon (Kugelform). Das Benetzungsverhalten wird durch den Kontaktwinkel, der mit handelsüblichen Messgeräten gemessen wird, ausgedrückt. Dabei bedeuten 100% Benetzung einen Kontaktwinkel (KW) von 0°.

Beispielhaft werden im Folgenden einige Möglichkeiten zur definierten Einstellung des polaren bzw. dispersen Anteiles der Oberflächenenergie und die Auswahl der einzubauenden Elemente in Relation zum Medium, mit dem diese Schichten kontaktiert werden sollen, aufgezeigt, wobei die Nummern 1, 2, 4 bis 7 Vergleichsbeispiele und die Nummer 3 ein erfindungsgemäßes Beispiel darstellen.
1. Bei Herstellung einer Si-enthaltenden Funktionsschicht unter Verwendung von **Tetramethylsilan** als Reaktivgas lässt sich die Oberflächenenergie von im PECVD-Prozess abgeschiedenen Hartstoffschichten durch Einstellen einer negativen Self-Bias an der HF-Elektrode von **U**_{**B**} **= 0,4-1,8 kV** im Bereich von **δ**^{**P**} **= 1.5-5.0 mN/m** für den polaren Anteil bzw. im Bereich von **δ**^{**d**} **= 29.0-32.0 mN/m** für den dispersen Anteil der Oberflächenenergie und durch Variation des Prozessdruckes von **P = 0.5-3.5 Pa** im Bereich von **δ**^{**P**} **= 7.0-2.5 mN/m** für den polaren bzw. **δ**^{**d**} **= 27.0-32.0 mN/m** für den dispersen Anteil der Oberflächenenergie definiert einstellen. Das Benetzungsverhalten gegenüber Wasser liegt im Bereich von 60 % bis 50%.
2. Ebenfalls bei Herstellung einer Si-enthaltenden Funktionsschicht aber unter Verwendung einer Mischung von **Tetramethylsilan** und **Sauerstoff** als Reaktivgas lässt sich die Oberflächenenergie der im PECVD-Prozess abgeschiedenen Hartstoffschichten bei einem Gasflussverhältnis der beteiligten Gase von **1:0.05 bis 1:5,** einer negativen Self-Bias an der HF-Elektrode von **U**_{**B**} **= 1.0 kV** und einem Prozessdruck von **P = 1.5 Pa** für den polaren Anteil der Oberflächenenergie im Bereich von **δ**^{**P**} **= 1.5-11.0 mN/m** und für den dispersen Anteil der Oberflächenenergie im Bereich von δ ^{**d**} **= 32.0-22.0 mN/m** definiert einstellen. Das zu erreichende Benetzungsverhalten gegenüber Wasser liegt dann im Bereich von 47 % bis 57 %.
3. Bei Herstellung einer Si- und 0-enthaltenden Funktionsschicht unter Verwendung einer entsprechenden Mischung von **Hexamethyldisiloxan** und **Sauerstoff** als Reaktivgas lässt sich die Oberflächenenergie der im PECVD-Prozess abgeschiedenen Hartstoffschichten bei einem Gasflussverhältnis der beteiligten Gase von **1:0.04 bis 1:4,** einer negativen Self-Bias an der HF-Elektrode von **U**_{**B**} **= 1.0 kV** und einem Prozessdruck von **P = 1.5 Pa** für den polaren Anteil der Oberflächenenergie im Bereich von **δ**^{**P**} **= 1.54.5 mN/m** und für den dispersen Anteil der Oberflächenenergie im Bereich von δ ^{**d**} **= 23.0-21.0 mN/m** definiert einstellen. Das Benetzungsverhalten gegenüber Wasser beträgt in diesem Fall von 43 % bis 50 %.
4. Bei Herstellung einer F-enthaltenden Funktionsschicht unter Verwendung einer entsprechenden Mischung von **Tetrafluorethylen** und **Acetylen** als Reaktivgas lässt sich die Oberflächenenergie der im PECVD-Prozess abgeschiedenen Hartstoffschichten bei einem Mischungsverhältnis der beteiligten Gase von **1:0.05 bis 1:1,** einer negativen Self-Bias an der HF-Elektrode von **U**_{**B**} **= 0.4 kV** und einem Prozessdruck von **P = 2.7 Pa** für den polaren Anteil der Oberflächenergie im Bereich von δ^{P} = **1.9-4.0 mN/m** und für den dispersen Anteil der Oberflächenenergie im Bereich von δ^{d} = **20.0-40.0 mN/m** definiert einstellen. Das zu erreichende Benetzungsverhalten gegenüber Wasser liegt im Bereich von 42 % bis 53 %.
5. Bei Herstellung einer Si-enthaltenden Funktionsschicht, die auch Spuren von Sauerstoff aufweist, unter Verwendung einer entsprechenden Mischung von **Tetraethoxysilan** und **Sauerstoff** als Reaktivgas lässt sich die Oberflächenenergie von im PECVD-Prozess abgeschiedenen Hartstoffschichten bei einem Gasflussverhältnis der beteiligten Gase von **1:0.1 bis 1:0.6,** einer negativen Self-Bias an der HF-Elektrode von **U**_{**B**} **= 1.0 kV** und einem Prozessdruck von **P = 1.5 Pa** für den polaren Anteil der Oberflächenenergie im Bereich von **δ** ^{**P**} **= 7.0-42.0 mN/m** definiert einstellen wobei der disperse Anteil der Oberflächenenergie **δ** ^{**d**} **= 29.0 mN/m** ist. Mit dieser Variante kann ein Benetzungsverhalten gegenüber Wasser im Bereich von 53 % bis 82 % erhalten werden.
6. Bei Herstellung einer O-enthaltenden Funktionsschicht unter Verwendung einer entsprechenden Mischung von **Acetylen** und **Sauerstoff** als Reaktivgas lässt sich die Oberflächenenergie der im PECVD-Prozess abgeschiedenen Hartstoffschichten bei einem Gasflussverhältnis der beteiligten Gase von **1:0.04 bis 1:2,** einer negativen Seif-Bias an der HF-Elektrode von **U**_{**B**} **= 0.6 kV** und einem Prozessdruck von **P = 1.0 Pa** für den polaren Anteil der Oberflächenenergie im Bereich von **δ**^{**P**} **= 6.0-24.0 mN/m** und für den dispersen Anteil der Oberflächenenergie im Bereich von δ ^{**d**} **= 40.0-28.0 mN/m** definiert einstellen. Das zu erreichende Benetzungsverhalten gegenüber Wasser liegt dann im Bereich von 58 % bis 72 %.
7. Bei Herstellung einer N-enthaltenden Funktionsschicht unter Verwendung einer entsprechenden Mischung von **Acetylen** und **Stickstoff** als Reaktivgas lässt sich die Oberflächenenergie der im PECVD-Prozess abgeschiedenen Hartstoffschichten bei einem Gasflussverhältnis der beteiligten Gase von **1:0.04,** einer negativen Seif-Bias an der HF-Elektrode von **U**_{**B**} **= 0.4-1.0 kV** und einem Prozessdruck von **P = 1.5 Pa** für den polaren Anteil der Oberflächenenergie im Bereich von δ ^{P} **= 25.0-13.0 mN/m** und für den dispersen Anteil der Oberflächenenergie im Bereich von δ ^{d} **= 25-33 mN/m** definiert einstellen. Das Benetzungsverhalten gegenüber Wasser, was mit dieser Variante erreichbar ist, liegt im Bereich von 71 % bis 65 %.

Wie aus einem Vergleich der vorstehenden Beispiele ersichtlich ist, können mit dem erfindungsgemäßen Verfahren Funktionsschichten erhalten werden, deren Benetzungsgrad z. B. gegenüber reinen C:H-Schichten verringert ist.

Die Funktionsschichten, die in Tabelle 1, Tabelle 2, Bild 1 und den nachfolgenden Ausführungsbeispielen zugrundeliegen, enthielten jeweils als Basiselemente Kohlenstoff und Wasserstoff.

### Vergleichsbeispiel 1

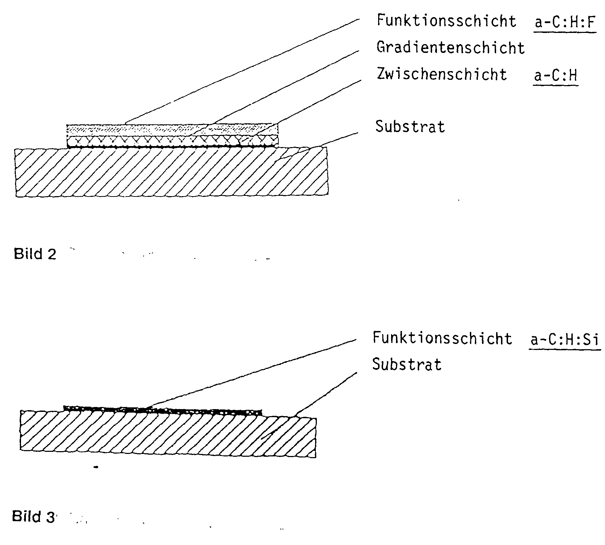

Das Verfahren zur Herstellung von amorphen Kohlenwasserstoffschichten wird am Beispiel einer fluorierten Funktionsschicht beschrieben. Zur Herstellung dieser Schicht wird das Substrat zuerst mit Argon bei einem Prozessdruck von P **= 1.0 Pa** und einer Bias von **U**_{**B**} **= -1.5 kV** zehn Minuten geätzt. Anschließend wird zur besseren Anbindung an das Substrat eine reine a-C:H Zwischenschicht (Gasfluss Q = 10-30 sccm Acetylen; Prozessdruck P = 1-2 Pa; Bias U_{B} = -400 bis -800 V) abgeschieden. Nachdem eine ausreichende Anbindung an das Substrat gesichert ist wird der Acetylengasfluss über eine Prozessdauer von zehn Minuten bis auf ca. 1-2 sccm -bei sonst gleichen Prozessbedingungen-ausgeblendet und ein Tetrafluorethylengasfluss C₂F₄ von 0 sccm auf ca. 30 sccm, wobei sccm Standardkubikzentimeter pro Minute bedeutet und mit "cm³/min unter Standardbedingungen" gleichzusetzen ist, eingeblendet. Im Anschluss an diese Gradientenschicht wird die Funktionsschicht etwa 20 Minuten mit dem zuletzt genannten Prozessparameter abgeschieden. Damit ergibt sich schematisch der in Bild 2 dargestellte Schichtaufbau.

Die EPMA-Analyse ergibt einen gemessenen Fluoranteil in der Funktionsschicht von ca. 33 at-%. Der technisch maximal erreichbare Fluoranteil bei den als a-C:H:F bezeichneten Schichten wird in einem Bereich wenig oberhalb der 33 at-% vermutet. Als Grund hierfür wird die dreidimensional vernetzte Struktur der polymerisierten Schichten angesehen. Jede weitere Erhöhung des Fluoranteils führt zu einer Erniedrigung des Vernetzungsgrades und somit zu einer im technischen Einsatz nur bedingt brauchbaren Schicht. Im Vergleich dazu liegt der Fluoranteil beim durchfluorierten Teflon bei ca. 66 at-%. Dabei ist jedoch zu berücksichtigen, dass Teflon ein Kettenmolekül ist und die räumliche Steifigkeit im wesentlichen durch seine Knäuelstruktur erhält.

Die Oberflächenspannung der a-C:H:F Schicht wird mit δₛ = 19.96 mN/m (dyn/cm) gesamt, δ ₛ^{p} = 2.2 mN/m (dyn/cm) für den polaren und δ ₛ^{d} = 17.74 mN/m (dyn/cm) für den dispersen Anteil ermittelt. Damit haben a-C:H:F Schichten hinsichtlich des Benetzungsverhaltens teflonähnliche Eigenschaften (s. u. ) bei einer gleichzeitig deutlich verbesserten Härte und Verschleißfestigkeit.

Der gemessene Kontaktwinkel gegen Wasser wird als quantitative Bewertungsgröße für das Benetzungsverhalten von Festkörperoberflächen aufgefasst und bei den mit Tetrafluorethylen C₂F₄ hergestellten Schichten mit Ø = 101 Grad gemessen. Werte für den Kontaktwinkel von Teflon gegen Wasser werden in der Literatur mit Ø = 114 Grad und die Daten zur Oberflächenspannung mit δₛ = 18.50 mN/m (dyn/cm) gesamt, δₛ^{p} = 1.00 mN/m (dyn/cm) für den polaren und δₛ^{d} = 17.50 mN/m (dyn/cm) für den dispersen Anteil angegeben.

### Vergleichsbeispiel 2

Das Verfahren zur Herstellung von amorphen Kohlenwasserstoffschichten wird am Beispiel einer a-C:H:Si Funktionsschicht beschrieben. Zur Herstellung dieser Schicht wird das Substrat zuerst mit Argon bei einem Prozessdruck von P = 1.0 Pa und einer Bias von U_{B} = -1.5 kV zehn Minuten geätzt. Im Anschluss an diese Reinigungsphase wird die Funktionsschicht mit einem Reaktivgas aus dem Precursermonomer Tetramethylsilane (TMS) abgeschieden. Diese Abscheidung wird bei einem Prozessdruck von P = 1.5 Pa und einer Bias von U_{B} = -1.000 V bei einem Gasfluss von Q = 20 sccm durchgeführt. Damit ergibt sich schematisch der in Bild 3 dargestellte Schichtaufbau.

Die Oberflächenspannung der a-C:H:Si Schicht wird mit δₛ = 31.20 mN/m (dyn/cm) gesamt, δₛ^{p} = 3.33 mN/m (dyn/cm) für den polaren und δ ₛ^{d} = 27.87 mN/m (dyn/cm) für den dispersen Anteil ermittelt.

Die EPMA-Analyse ergibt eine Elementzusammensetzung von Si = 33.1 at-% und C = 66.6 at-%.

Es konnte somit gezeigt werden, dass mit der erfindungsgemäßen Schicht die Aufgabe gelöst wurde und Hartstoffschichten mit definiert einstellbaren Adhäsionsverhalten erhalten werden konnten.

## Patentansprüche

1. Verfahren zur Herstellung einer Plasmapolymer-Schichtenfolge auf einem Substrat durch einen Plasma-Enhanced-Chemical-Vapor-Depositon (PECVD)-Prozess, bestehend aus einer äußersten Funktionsschicht und einer gegebenenfalls zwischen Substrat und Funktionsschicht angeordneten Zwischenschicht, wobei die Funktionsschicht als Hartstoffschicht ausgebildet ist, welche die Basiselemente Kohlenstoff (C) und Wasserstoff (H) sowie die Zusatzelemente Silizium (Si) und Sauerstoff (O) enthält,
**dadurch gekennzeichnet,**
**dass** das Reaktivgas zur Abscheidung der Hartstoffschicht aus einer Mischung aus Hexamethyldisiloxan (HMDSO) und Sauerstoff besteht und die so hergestellte Funktionsschicht einen Benetzungsgrad gegenüber Wasser von 43 bis 50 % aufweist.

2. Verfahren nach Anspruch 1,
**dadurch gekennzeichnet,**
**dass** zur Verbesserung der Haftung der Funktionsschicht auf dem Substrat vor Zuführung des Reaktivgases in den Prozess eine der Haftvermittlung zwischen Substrat und Funktionsschicht dienende Zwischenschicht abgeschieden wird, wobei der Wechsel der Prozessatmosphäre zwischen Abscheidung der Zwischenschicht und der Abscheidung der Funktionsschicht ohne Unterbrechung erfolgt.

3. Verfahren nach Anspruch 2,
**dadurch gekennzeichnet,**
**dass** der Übergang von der die reine Zwischenschicht bildenden Prozessatmosphäre zu der die reine Funktionsschicht bildenden Prozessatmosphäre schrittweise erfolgt, so dass zwischen der Zwischenschicht und der Funktionsschicht eine Gradientenschicht abgeschieden wird.

4. Verfahren nach Anspruch 2 oder 3,
**dadurch gekennzeichnet,**
**dass** die der Haftvermittlung dienende Zwischenschicht aus einer Acetylen-oder einer Tetramethylsilanatmosphäre abgeschieden wird.

5. Schichtenfolge auf einem Substrat, erhältlich nach einem der vorstehend genannten Verfahren, wobei die äußerste Funktionsschicht
- als Hartstoffschicht ausgebildet ist,
- als Basiselemente Kohlenstoff (C) und Wasserstoff (H) aufweist,
- zusätzlich zu den Basiselementen Kohlenstoff (C) und Wasserstoff (H) auch Silizium (Si) und Sauerstoff (O) enthält und
- einen Benetzungsgrad gegenüber Wasser von 43 bis 50 % aufweist.

6. Schichtenfolge nach Anspruch 5,
**dadurch gekennzeichnet,**
**dass** unterhalb der Funktionsschicht eine Zwischenschicht zur Haftverbesserung angeordnet ist.

7. Verwendung der Schichtenfolge nach Anspruch 5 oder 6 als Schutzschichten.

8. Verwendung nach Anspruch 7 als Schutzschichten in der Haushaltswarenindustrie, in der Nahrungsmittelindustrie, in der Lack- und Druckindustrie, im allgemeinen Maschinenbau und in der Medizintechnik.

9. Verwendung nach einem der Ansprüche 7 oder 8 als Schutzschichten gegen Verschmutzung und/oder Verkalkung und/oder Schmierungen.

10. Verwendung nach Anspruch 9 als Schutzschicht auf Heizstäben in Waschmaschinen.

## Claims

1. Process for the production of a plasma polymer layer sequence on a substrate by means of a plasma enhanced chemical vapour deposition (PECVD) process, comprising an outermost function layer and an intermediate layer possibly disposed between the substrate and function layer, said function layer being configured as a hard material layer, which contains the base elements carbon (C) and hydrogen (H) as well as the supplementary elements silicon (Si) and oxygen (O),
**characterised in that**
the reactive gas for deposition of the hard material layer is composed of a mixture of hexamethyl disiloxane (HMDSO) and oxygen and the thus produced function layer has a wetting rate relative to water of 43 to 50%.

2. Process according to Claim 1,
**characterised in that**
to improve adhesion of the function layer on the substrate, an intermediate layer serving to promote adhesion between the substrate and function layer is deposited before feeding the reactive gas into the process, whereby the change in process atmosphere between deposition of the intermediate layer and deposition of the function layer occurs without interruption.

3. Process according to Claim 2,
**characterised in that**
the transition from the process atmosphere forming the pure intermediate layer to the process atmosphere forming the pure function layer occurs in steps so that a gradient layer is deposited between the intermediate layer and the function layer.

4. Process according to Claim 2 or 3,
**characterised in that**
the intermediate layer serving to promote adhesion is deposited from an acetylene or a tetramethylsilane atmosphere.

5. Layer sequence on a substrate, which may be obtained according to one of the processes mentioned above, wherein the outermost function layer
- is configured as a hard material layer,
- has carbon (C) and hydrogen (H) as base elements,
- also contains silicon (Si) and oxygen (O) in addition to the base elements carbon (C) and hydrogen (H) , and
- has a wetting rate relative to water of 43 to 50%.

6. Layer sequence according to Claim 5,
**characterised in that**
an intermediate layer is disposed under the function layer to improve adhesion.

7. Use of the layer sequence according to Claim 5 or 6 as protective layers.

8. Use according to Claim 7 as protective layers in the household appliance industry, in the food industry, in the paint and printing industry, in general machine construction and in medical engineering.

9. Use according to one of Claims 7 or 8 as protective layers against dirt and/or calcification and/or lubrications.

10. Use according to Claim 9 as protective layer on heating elements in washing machines.

## Revendications

1. Procédé de fabrication d'une superposition de couches de polymère-plasma sur un substrat, au moyen d'un processus de dépôt chimique en phase vapeur assisté par plasma (processus PECVD), comprenant une couche fonctionnelle extérieure et une couche intermédiaire disposée, le cas échéant, entre le substrat et la couche fonctionnelle, la couche fonctionnelle étant une couche de carbure, qui contient les éléments de base carbone (C) et hydrogène (H), ainsi que les éléments ajoutés silicium (Si) et oxygène (O), **caractérisé en ce que** le gaz réactif, utilisé pour le processus de déposition de la couche de carbure, est formé par un mélange d'hexaméthyl-disiloxane et d'oxygène (HMDSO), et la couche fonctionnelle ainsi obtenue présente un coefficient de mouillage de 43 à 50 % par rapport à l'eau.

2. Procédé selon la revendication 1, **caractérisé en ce qu'**en vue d'améliorer l'adhérence de la couche fonctionnelle sur le substrat, avant l'admission du gaz réactif dans le processus, il est prévu de déposer une couche intermédiaire destinée à produire l'adhérence entre le substrat et la couche fonctionnelle, le changement d'atmosphère en cours de processus, entre le dépôt de la couche intermédiaire et le dépôt de la couche fonctionnelle, étant effectué sans interruption.

3. Procédé selon la revendication 2, **caractérisé en ce que** la transition entre l'atmosphère pour déposer la couche intermédiaire pure et l'atmosphère pour déposer la couche fonctionnelle pure est effectuée progressivement, de telle sorte qu'une couche à gradient d'indice soit déposée entre la couche intermédiaire et la couche fonctionnelle.

4. Procédé selon la revendication 2 ou 3, **caractérisé en ce que** la couche intermédiaire destinée à produire l'adhérence est déposée dans une atmosphère d'acétylène ou une atmosphère de tétraméthyl-silane.

5. Superposition de couches sur un substrat, obtenue selon l'une quelconque des revendications précédentes, dans laquelle la couche fonctionnelle extérieure
- est une couche de carbure,
- contient les éléments de base carbone (C) et hydrogène (H),
- contient, en plus des éléments de base carbone (C) et hydrogène (H), aussi du silicium (Si) et de l'oxygène (O), et
- présente un coefficient de mouillage de 43 à 50 % par rapport à l'eau.

6. Superposition de couches selon la revendication 5, **caractérisée en ce que**, dans le but d'améliorer l'adhérence, une couche intermédiaire est disposée au-dessous de la couche fonctionnelle.

7. Utilisation de la superposition de couches selon la revendication 5 ou 6 sous forme de couches de protection.

8. Utilisation selon la revendication 7 sous forme de couches de protection dans l'industrie des articles ménagers, dans l'industrie alimentaire, dans l'industrie des peintures et vernis et l'industrie typographique, dans la construction mécanique générale et dans la technique médicale.

9. Utilisation selon la revendication 7 ou 8 sous forme de couches de protection contre l'encrassement et/ou l'entartrage et/ou la lubrification.

10. Utilisation selon la revendication 9 sous forme de couches de protection sur les cartouches chauffantes dans les machines à laver.
